# EUROPÄISCHE PATENTANMELDUNG

(11) **EP 1 022 768 A2**
(43) Veröffentlichungstag der Anmeldung: **26.07.2000**
(21) Anmeldenummer: 00200073.5
(22) Anmeldetag: 11.01.2000
(51) Int. Cl.: H01L 21/02

(54) **Spannungsfester Dünnschichtkondensator mit Interdigitalstruktur**

(30) Priorität: 20.01.1999 DE 19902029
(71) Anmelder: Philips Corporate Intellectual Property GmbH, 52064 Aachen (DE); Koninklijke Philips Electronics N.V., 5621 BA Eindhoven (NL)
(72) Erfinder: Klee, Mareike, Philips Corporate Intel. Prop. GmbH, 52046 Aachen (DE); Hermann, Wilhelm, Philips Corp. Intel. Prop. GmbH, 52064 Aachen (DE); Mackens, Uwe, Philips Corporate Intel. Prop. GmbH, 52064 Aachen (DE); Keizer, Paulus, Philips Corporate Intel.Prop. GmbH, 52064 Aachen (DE)
(74) Vertreter: Volmer, Georg, Dipl.-Ing.

(57) **Zusammenfassung**

Die Erfindung betrifft einen Dünnschichtkondensator mit einem Trägersubstrat (1), wenigstens zwei interdigitalen Elektroden (4, 5) und einem Dielektrikum (3). Durch eine versetzte Anordnung wenigstens einer interdigitalen Elektrode (4) unterhalb des Dielektrikums (3) zu einer interdigitalen Elektrode (5) oberhalb des Dielektrikums (3) wird ein spannungsfester Dünnschichtkondensator erhalten, der mit dem gleichen Produktionsprozeß hergestellt werden kann, wie ein Standard-Monolagenkondensator.

## Beschreibung

Die Erfindung betrifft einen Dünnschichtkondensator, welcher ein Trägersubstrat, wenigstens zwei interdigitale Elektroden und wenigstens ein Dielektrikum aufweist.

Dielektrische Materialien mit hohen Dielektrizitätskonstanten (εᵣ > 50) werden eingesetzt, um in Kondensatoren hohe Kapazitäten auf kleinen Abmessungen zu erreichen. Bei der Herstellung von Dünnschichtkondensatoren werden mittels Dünnschichtprozessen Dielektrika mit εᵣ > 50 in dielektrischen Dicken von 50 nm bis 2 µm hergestellt Als kostengünstiges Verfahren zur Abscheidung dünner Schichten mit εᵣ > 50 wird ein naßchemisches Dünnschichtverfahren wie beispielsweise das Sol-Gel-Verfahren eingesetzt. Als Grundelektrode dient in den Dünnschichtkondensatoren eine Nichtedelmetallelektrode wie zum Beispiel eine Aluminium- oder Kupferelektrode oder auch eine Edelmetallelektrode beispielsweise aus Silber, Silberlegierungen oder Platin. Für die Oberelektrode werden wie bei der Grundelektrode Edelmetalle wie zum Beispiel Platin, Silber, Silberlegierungen oder NiCr/Gold oder auch Nichtedelmetalle wie zum Beispiel Aluminium, Nickel oder Kupfer eingesetzt. Diese werden mit Dünnschichtverfahren wie zum Beispiel Sputtern oder chemische Abscheidung aus der Gasphase aufgebracht. Zur Strukturierung der Elektroden werden lithographische Prozesse verbunden mit Naß- oder Trockenätzschritten verwendet. Als Trägersubstratmaterialien kommen Si-Wafer, Glas- oder Keramikmaterialien zur Anwendung. Zum Schutz des Kondensatoraufbaus wird eine Schutzschicht beispielsweise eine organische Schicht und/oder eine anorganische Schicht durch ein Druckverfahren oder ein Dünnschichtverfahren aufgebracht. Außerdem werden die Kondensatoren entweder einzeln oder in Streifen mit Stromzuführungen versehen.

Dieser Stand der Technik reicht aus, um kostengünstige, den Standardspezifikationen entsprechende, Dünnschichtkondensatoren herzustellen. Die Schichtdicken von etwa einem Mikrometer reichen aber nicht aus, um für Hochfrequenzanwendungen bei kleinen Kapazitätswerten von einigen Picofarad höhere Betriebsspannungen U_{rated} (50 V, 100 V und höher) mit den zusätzlich geforderten Lebensdauern zu erreichen.

Eine höhere Spannungsfestigkeit zeigen sogenannte Interdigitalkondensatoren, deren Elektroden eine Fingerstruktur aufweisen. Die fingerartigen Ausbildungen dieser interdigitalen Elektroden und deren Verzahnung bilden mit dem darüberliegenden Dielektrikum den eigentlichen Kondensator. Die Kapazität einer solchen Anordnung ist eine Funktion des Fingerabstandes, der Länge der Verzahnung, der Dicke des Dielektrikums, der Dielektrizitätskonsranten von Substrat und Dielektrikum und der Dicke der Elektroden. Der Fingerabstand bestimmt im wesentlichen die Durchschlagfestigkeit und damit die zulässige Betriebsspannung des Kondensatortyps.

Aus Publikationsnummer 07283076 A der "Patent Abstracts of Japan" ist eine Kondensatoranordnung mit interdigitalen Elektroden bekannt, bei der zusätzlich zur Erhöhung der Kapazität mehrere interdigitale Elektrodenschichten übereinander angeordnet sind. Die interdigitalen Elektroden einer Kondensatoreinheit liegen jeweils in einer Ebene und zwischen den einzelnen Elektrodenebenen befindet sich ein Dielektrikum. Ein Nachteil der Anordnung der Elektroden in einer Ebene besteht darin, daß nicht die volle Dicke des Dielektrikums zur Kapazität des Kondensators beiträgt.

Der Erfindung liegt die Aufgabe zugrunde, einen verbesserten Dünnschichtkondensator mir interdigitalen Elektroden und hoher Spannungsfestigkeit zu entwickeln.

Die Aufgabe wird gelöst durch einen Dünnschichtkondensator, welcher ein Trägersubstrat, wenigstens zwei interdigitale Elektroden und wenigstens ein Dielektrikum aufweist, dadurch gekennzeichnet, daß wenigstens eine interdigitale Elektrode unterhalb und wenigstens eine interdigitale Elektrode oberhalb des Dielektrikums angeordnet ist.

Bei der Anordnung der interdigitalen Elektroden unter- und oberhalb des Dielektrikums tragen die Schichten des Dielektrikums zum Kapazitätsverhalten des Kondensators bei.

Eine bevorzugte Ausführung sieht vor, daß die interdigitale Elektrode oberhalb des Dielektrikums versetzt zu der interdigitale Elektrode unterhalb des Dielektrikums angeordnet ist.

Diese versetzte Anordnung bewirkt, daß das Dielektrikum gleichmäßiger vom elektrischen Feld durchdrungen wird und somit höhere Kapazitäten erzielt werden können, bei sonst identischen Parametern.

Eine weitere bevorzugte Ausführung sieht vor, daß das Dielektrikum multiple Schichten aufweist.

Durch Verwendung von multiplen Schichten, beispielsweise Doppel-, Dreifach- oder Vierfachschichten, kann das ungünstige Temperaturverhalten einiger dielektrischer Materialien ausgeglichen und die Temperaturabhängigkeit des Kapazitätswertes des Dünnschichtkondensators verbessert werden.

In einer bevorzugten Ausführung enthält das Dielektrikum ein ferroelektrisches Keramikmaterial.

Ferroelektrische Keramikmaterialien besitzen eine große relative Dielektrizitätskonstante εᵣ und ermöglichen hohe Kapazitäten auf kleinen Abmessungen.

Es ist außerdem bevorzugt, daß auf dem Trägersubstrat eine Barriereschicht aufgebracht ist.

Durch eine Barriereschicht können bei oberflächenrauhen Trägersubstraten, beispielsweise Al₂O₃, Reaktionen mit dem Dielektrikum oder Kurzschlüsse vermieden werden.

Im folgenden soll die Erfindung anhand einer Figur und zweier Ausführungsbeispiele erläutert werden. Dabei zeigt
- Fig. 1:: den schematischen Aufbau eines Dünnschichtkondensators mit zwei interdigitalen Elektroden
und
- Fig. 2:: den schematischen Aufbau eines Dünnschichtkondensators mit drei interdigitalen Elektroden.

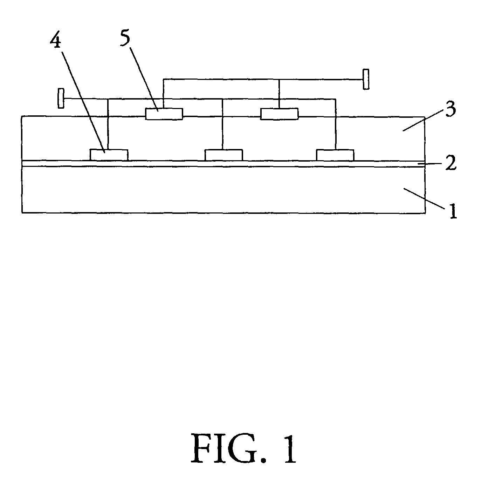

Gemäß Fig. 1 weist ein Dünnschichtkondensator ein Trägersubstrat 1 auf, welches zum Beispiel aus einem keramischen Material, einem glaskeramischen Material, einem Glasmaterial oder Silicium ist. Auf dem Trägersubstrat 1 ist eine Barriereschicht 2 beispielsweise aus SiO₂, TiO₂, Al₂O₃ oder ZrO₂ aufgebracht. Auf dieser Barriereschicht 2 befindet sich eine erste interdigitale Elektrode 4, welche beispielsweise Al,
Al dotiert mit Cu,
Cu,
W,
Pt,
Ni,
Pd,
Pd/Ag,
TiW/Al,
Ti/Pt,
Ti/Ag,
Ti/Ag/TiIr,
Ti/AgₓPt₁₋ₓ (0 ≤ x ≤ 1),
Ti/Ag/PtₓAl₁₋ₓ (0 ≤ x ≤ 1),
Ti/AgₓPt₁₋ₓ/Ir (0 ≤ x ≤ 1),
Ti/Ag/(Ir/IrOₓ) (0 ≤ x ≤ 2),
Ti/Ag/RuₓPt₁₋ₓ (0 ≤ x ≤ 1),
Ti/PtₓAl₁₋ₓ/Ag/Pt_{y}Al_{1-y} (0 ≤ x ≤ 1, 0 ≤ y ≤ 1),
Ti/Ag/Pt_{y}(RhOₓ)_{1-y} (0 ≤ x ≤ 2, 0 ≤ y ≤ 1),
Ti/Ag/PtₓRh₁₋ₓ (0 ≤ x ≤ 1),
Ti/AgₓPt₁₋ₓ/(Ir/IrO_{y}) (0 ≤ x ≤ 1, 0 ≤ y ≤ 2),
Ti/AgₓPt₁₋ₓ/Pt_{y}Al_{1-y} (0 ≤ x ≤ 1, 0 ≤ y ≤ 1),
Ti/Ag/Ti,
Ti/Ni/ITO oder NiₓCr_{y}Al_{z}/Ni (0 ≤ x ≤ 1, 0 ≤ y ≤ 1, 0 ≤ z ≤ 1) enthält. Auf der unteren interdigitalen Elektrode 4 wird ein Dielektrikum 3 aufgebracht, welches eine hohe relative Dielektrizitätskonstante von εᵣ > 20 aufweist. Das Dielektrikum 3 kann zum Beispiel
Pb(ZrₓTi₁₋ₓ)O₃ (0 ≤ x ≤ 1) mir und ohne Bleiüberschuß,
(Pb,Ba)(Mg_{1/3}Nb_{2/3})ₓ(Zn_{1/3}Nb_{2/3})_{y}Ti₂O₃ (0 ≤ x ≤ 1, 0 ≤ y ≤ 1, 0 ≤ z ≤ 1),
Ba₁₋ₓSrₓTiO₃ (0 ≤ x ≤ 1),
Pb_{1-1.5y}La_{y}(ZrₓTi₁₋ₓ)O₃ (0 ≤ x ≤ 1, 0 ≤ y ≤ 0.2),
SrTi₁₋ₓZrₓO₃ (0 ≤ x ≤ 1),
(Zr,Sn)TiO₄,
Ta₂O₅ mit Al₂O₃ Dotierungen,
Pb_{1-αy} La_{y}TiO₃ (0 ≤ y ≤ 0.3, 1.3 ≤ α ≤ 1.5),
(Pb,Ca)TiO₃,
BaTiO₃ mit und ohne Dotierungen,
Ba₂Ti₉O₂₀,
CaSm₂Ti₅O₁₄,
TiZr_{0.8}Sn_{0.2}O₄,
Ba₂Ti_{8.53}Zr_{0.50}Mn_{0.01}O₂₀,
SrZrₓTi₁₋ₓO₃ (0 ≤ x ≤ 1) mit und ohne Mn Dotierungen,
BaZrₓTi₁₋ₓO₃ (0 ≤ x ≤ 1),
Ba_{1-y}Sr_{y}ZrₓTi₁₋ₓO₃ (0 ≤ x ≤ 1, 0 ≤ y ≤ 1),
SrTiO₃ mir Dotierungen von z.B. La, Nb, Fe oder Mn,
(BaTiO₃)_{0.18-027} + (Nd₂O₃)_{0.316-0.355} + (TiO₂)_{0.276-0.355} + (Bi₂O₃)_{0.025-0.081} + x ZnO,
CaZrO₃,
CaTiO₃ + CaTiSiO₅,
(Sr,Ca)(Ti,Zr)O₃,
(Sr,Ca,M)(Ti,Zr)O₃ (M= Mg oder Zn),
(Sr,Ca,Cu,Mn,Pb)TiO₃ + Bi₂O₃,
BaO-TiO₂-Nd₂O₃-Nb₂O₅,
(Ba,Ca)TiO₃ + Nb₂O₅, Co₂O₃, MnO₂,
TiO₂,
BaO-PbO-Nd₂O₃-TiO₂,
Ba(Zn,Ta)O₃,
BaZrO₃,
Nd₂Ti₂O₇,
PbNbₓ((Zr_{0.6}Sn_{0.4})_{1-y}Ti_{y}))₁₋ₓO₃ (0 ≤ x ≤ 0.9, 0 ≤ y ≤ 1),
Pb(Mg_{1/3}Nb_{2/3})O₃]ₓ-[PbTiO₃]₁₋ₓ (0 ≤ x ≤ 1),
(Pb,Ba,Sr)(Mg_{1/3}Nb_{2/3})ₓTi_{y}(Zn_{1/3}Nb_{2/3})_{1-x-y}O₃ (0 ≤ x ≤ 1, 0 ≤ y ≤ 1, x + y ≤ 1),

a) Pb(Mg_{1/2}W_{1/2})O₃
b) Pb(Fe_{1/2}Nb_{1/2})O₃
c) Pb(Fe_{2/3}W_{1/3})O₃
d) Pb(Ni_{1/3}Nb_{2/3})O₃
e) Pb(Zn_{1/3}Nb_{2/3})O₃
f) Pb(Sc_{1/2}Ta_{1/2})O₃
sowie Kombinationen der Verbindungen a)- f) mit PbTiO₃ und Pb(Mg_{1/3}Nb_{2/3})O₃ mit und ohne Bleiüberschuß enthalten. Auf dem Dielektrikum 3 ist eine obere interdigitale Elektrode 5 aufgebracht, die zum Beispiel Al,
Al dotiert mit Cu,
Cu,
W,
Pt,
Ni,
Pd,
Pd/Ag,
TiW/Al,
Ti/Pt,
Ti/Ag,
Ti/Ag/TiIr,
Ti/AgₓPt₁₋ₓ (0 ≤ x ≤ 1),
Ti/Ag/PtₓAl₁₋ₓ (0 ≤ x ≤ 1),
Ti/AgₓPt₁₋ₓ/Ir (0 ≤ x ≤ 1),
Ti/Ag/(Ir/IrOₓ) (0 ≤ x ≤ 2),
Ti/Ag/RuₓPt₁₋ₓ (0 ≤ x ≤ 1),
Ti/PtₓAl₁₋ₓ/Ag/Pt_{y}Al_{1-y} (0 ≤ x ≤ 1, 0 ≤ y ≤ 1),
Ti/Ag/Pt_{y}(RhOₓ)_{1-y} (0 ≤ x ≤ 2, 0 ≤ y ≤ 1),
Ti/Ag/PtₓRh₁₋ₓ (0 ≤ x ≤ 1),
Ti/AgₓPt₁₋ₓ/(Ir/IrO_{y}) (0 ≤ x ≤ 1, 0 ≤ y ≤ 2),
Ti/AgₓPt₁₋ₓ/Pt_{y}Al_{1-y} (0 ≤ x ≤ 1, 0 ≤ y ≤ 1),
Ti/Ag/Ti,
Ti/Ni/ITO oder
NiₓCr_{y}Al_{z}/Ni (0 ≤ x ≤ 1, 0 ≤ y ≤ 1, 0 ≤ z ≤ 1) enthält.

Alternativ kann das Dielektrikum 3 multiple Schichten, beispielsweise Doppel-, Dreifach- oder Vierfachschichten, aufweisen.

Außerdem kann ein Mehrschichtraufbau mir drei oder mehr versetzten interdigitalen Elektroden eingesetzt werden.

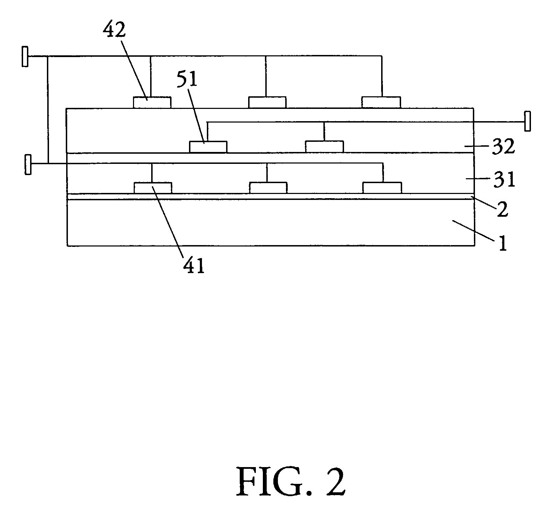

In Fig. 2 ist ein solcher Mehrschichtaufbau mit drei versetzten interdigitalen Elektroden 41, 42 und 51 und zwei Dielektrika 31 und 32 gezeigt. In dieser Ausführung des erfindungsgemäßen Dünnschichtkondensators befinden sich über einer ersten interdigitalen Elektrode 41 zunächst ein erstes Dielektrikum 31, darüberliegend eine zweite interdigitale Elektrode 51, darüberliegend ein zweites Dielektrikum 32 und eine dritte interdigitale Elektrode 42. Die erste interdigitale Elektrode 41 und die dritte interdigitale Elektrode 42 sind parallel geschahen.

Im folgenden werden Ausführungsformen der Erfindung erläutert, die beispielhafte Realisierungsmöglichkeiten darstellen.

### Ausführungsbeispiel 1:

Ein Trägersubstrat 1 aus Glas wird mit einer Barriereschicht 2 aus TiO₂ versehen. Auf diese Barriereschicht 2 wird eine untere interdigitale Elektrode 4 aus Ti/Pt aufgebracht. Über der unteren interdigitalen Elektrode 4 befindet sich ein Dielektrikum 3 aus BaTiO₃.

Auf dieses Dielektrikum 3 wird eine obere interdigitale Elektrode 5 aus Pt aufgebracht.

### Ausführungsbeispiel 2:

Ein Trägersubstrat 1 aus Glas wird mit einer Barriereschicht 2 aus TiO₂ versehen. Auf diese Barriereschicht 2 wird eine untere interdigitale Elektrode 4 aus Ti/Pt aufgebracht. Über der unteren interdigitalen Elektrode 4 befindet sich ein Dielektrikum 3 aus Lanthandotiertem Pb(Zr_{0.53}Ti_{0.47})O₃. Auf dieses Dielektrikum 3 wird eine obere interdigitale Elektrode 5 aus Pt aufgebracht.

Im gleichen Herstellungsprozeß werden auch Srandard-Monolagenkondensatoren hergestellt. Die Ergebnisse aus drei Versuchen sind in Tabelle 1 zusammengefaßt.

**Tabelle 1**

| Srandard-Monolagenkondensator mit 20 V/µm und 13 nF/mm² | | | | |
|---|---|---|---|---|
| | Versuch 1 | Versuch 2 | Versuch 3 | Mittelwert |
| rel. Dielektrizitätskonstante εᵣ | 1120 | 1060 | 1070 | 1083 |
| Dielektrikum [µm] | 0.754 | 0.784 | 0.702 | 0.747 |
| Betriebsspannung U_{rated} [V] | | | | 15 |

**Tabelle 2**

| Parameter für die interdigitalen Elektroden | |
|---|---|
| Anzahl der Finger: | 12 |
| Anzahl der Lücken: | 11 |
| Länge der Verzahnung [µm]: | 850 |
| Gesamtlänge der Verzahnung [µm]: | 9350 |

In Tabelle 3 sind die gemittelten Kapazitätswerte C und die Betriebsspannungen U_{rated} für Dünnschichtkondensatoren mit interdigitalen Elektroden (Parameter entsprechend Tabelle 2) und Lanthan-dotiertem PZT-Dielektrikum (Schichtdicken entsprechend Tabelle 1) angegeben.

**Tabelle 3**

| Gemittelte Kapazitätswerte C für Dünnschichtkondensatoren mit interdigitalen Elektroden und Lanthan dotierten PZT-Dielektrikum. | | |
|---|---|---|
| Fingerabstand [µm] | Kapazität C [pF] | Betriebsspannung U_{rated} [V] |
| 10 | 6.3 | 200 |
| 5 | 10.8 | 100 |
| 3 | 17.5 | 60 |

## Patentansprüche

1. Dünnschichtkondensator, welcher ein Trägersubstrat (1), wenigstens zwei interdigitale Elektroden (4, 5) und wenigstens ein Dielektrikum (3) aufweist,
dadurch gekennzeichnet,
daß wenigstens eine interdigitale Elektrode (4) unterhalb und wenigstens eine interdigitale Elektrode (5) oberhalb des Dielektrikums (3) angeordnet ist.

2. Dünnschichtkondensator nach Anspruch 1,
dadurch gekennzeichnet,
daß die interdigitale Elektrode (5) oberhalb des Dielektrikums (3) versetzt zu der interdigitalen Elektrode (4) unterhalb des Dielektrikums (3) angeordnet ist.

3. Dünnschichtkondensator nach Anspruch 1,
dadurch gekennzeichnet,
daß das Dielektrikum (3) multiple Schichten aufweist.

4. Dünnschichtkondensator nach Anspruch 1,
dadurch gekennzeichnet,
daß das Dielektrikum (3) ein ferroelektrisches Keramikmaterial enthält.

5. Dünnschichtkondensator nach Anspruch 1,
dadurch gekennzeichnet,
daß auf dem Trägersubstrat (1) eine Barriereschicht (2) aufgebracht ist.
